# EUROPEAN PATENT APPLICATION

(11) **EP 4 745 529 A1**
(43) Date of publication of application: **20.05.2026**
(21) Application number: 25211875.7
(22) Date of filing: 29.10.2025
(51) Int. Cl.: G01D 5/347

(54) **REFLECTIVE OPTICAL UNIT AND ENCODER**

(30) Priority: 18.11.2024 JP 2024201136; 10.06.2025 JP 2025097025
(71) Applicant: Dexerials Corporation, Shimotsuke-shi, Tochigi 323-0194 (JP)
(72) Inventor: ITAZAKI, Yu, Shimotsuke-shi, Tochigi 3230194 (JP); YANAGASE, Masashi, Shimotsuke-shi, Tochigi 3230194 (JP)
(74) Representative: Scott, Stephen John

(57) **Abstract**

A reflective optical unit (1) according to the present disclosure includes a substrate (40) and a light-emitting element (10) and light-receiving element (30) located on the substrate (40). The difference between a first height (H1) of a first surface (S1) of the light-emitting element (10) relative to the substrate (40), the first surface (S1) facing away from the substrate (40), and a second height (H2) of a second surface (S2) of the light-receiving element (30) relative to the substrate (40), the second surface (S2) facing away from the substrate (40), is equal to or less than the thickness of the light-emitting element (10), and the light-emitting element (10) has a thin film shape. The reflective optical unit (1) is capable of reducing signal variations.

## Description

### TECHNICAL FIELD

The present disclosure relates to a reflective optical unit and an encoder. The present disclosure relates to a reflective optical unit for use in a rotary encoder having the configuration described below, for example.

### BACKGROUND

Conventional techniques related to encoders are known. For example, Patent Literature (PTL) 1 discloses that in a reflective rotary encoder using an optical sensor in which the light-receiving element and the light-emitting element are not coplanar, a decrease in angular resolution or angular accuracy caused by axial positional fluctuations of the rotation axis of the code wheel is suppressed.

### CITATION LIST

### Patent Literature

PTL 1: JP 2021-015071 A

### SUMMARY

For example, in the conventional technology described in PTL 1, the reflective rotary encoder needs to achieve measurement with higher accuracy than before in applications in which more space needs to be saved. For example, known techniques have room for improvement in reducing signal variations.

It would be helpful to provide a reflective optical unit and an encoder capable of reducing signal variations.

As a result of intensive research, we devised a "reflective optical unit" having the above configuration and an "encoder" including the reflective optical unit.
(1) A reflective optical unit comprising:
   a substrate; and
   at least one light-emitting element and a light-receiving element located on the substrate, wherein
   a difference between a first height of a first surface of the light-emitting element relative to the substrate, the first surface facing away from the substrate, and a second height of a second surface of the light-receiving element relative to the substrate, the second surface facing away from the substrate, is equal to or less than a thickness of the light-emitting element, and
   the light-emitting element has a thin-film shape.
(2) The reflective optical unit according to (1), wherein
   a tolerance of the difference is in a range of 0 µm to 5 µm.
(3) The reflective optical unit according to (1) or (2), further comprising
   a reflector configured to reflect light, emitted from a light-emitting surface of the light-emitting element, toward a light-receiving surface of the light-receiving element, wherein
   a first optical path length between the light-emitting surface included in the first surface and a reflecting surface of the reflector is defined as L1,
   a second optical path length between the light-receiving surface included in the second surface and the reflecting surface is defined as L2, and
   an error between L1 and L2 is in a range of 0 % to 5 %.
(4) The reflective optical unit according to any one of (1) to (3), wherein
   the light-receiving element is located directly above the substrate, and
   the light-emitting element is located directly above the light-receiving element.
(5) The reflective optical unit according to (4), wherein an edge portion of the light-emitting element and a circuit pattern located on the second surface are electrically connected directly via a conductive material without using a wire.
(6) The reflective optical unit according to (4), wherein the light-emitting element is electrically connected to a circuit pattern located on the second surface by a transparent electrode that covers an entire surface of the light-emitting element.
(7) A reflective optical unit according to any one of (4) to (6), wherein the light-receiving element comprises a recess in the second surface, and the light-emitting element is disposed in the recess.
(8) The reflective optical unit according to any one of (1) to (7), wherein the at least one light-emitting element comprises a plurality of light-emitting elements in close proximity to each other.
(9) The reflective optical unit according to any one of (1) to (8), wherein the thickness of the light-emitting element is in a range of 0.5 µm to 20 µm.
(10) An encoder comprising the reflective optical unit according to (3).
(11) The encoder according to (10), wherein
   the encoder comprises a rotary encoder, and
   the reflector comprises a code wheel.

According to the present disclosure, a reflective optical unit and an encoder capable of reducing signal variations can be provided.

### BRIEF DESCRIPTION OF THE DRAWINGS

In the accompanying drawings:
FIG. 1A is an external perspective view schematically illustrating a first example of a configuration of a reflective optical unit according to an embodiment of the present disclosure;
FIG. 1B is an enlarged view of the area enclosed by the dashed dotted line in FIG. 1A;
FIG. 2 is a cross-sectional view schematically illustrating a cross-section taken along the line II-II of FIG. 1A;
FIG. 3 is a first cross-sectional view schematically illustrating a cross-section of a second example of a configuration of a reflective optical unit according to an embodiment of the present disclosure;
FIG. 4 is a second cross-sectional view schematically illustrating a cross-section of the second example of the configuration of the reflective optical unit according to an embodiment of the present disclosure;
FIG. 5 is a cross-sectional view schematically illustrating a cross-section of a third example of a configuration of a reflective optical unit according to an embodiment of the present disclosure;
FIG. 6 is a cross-sectional view schematically illustrating a cross-section of a fourth example of a configuration of a reflective optical unit according to an embodiment of the present disclosure;
FIG. 7A is a cross-sectional view schematically illustrating a cross-section of a first example of a configuration of a reflective optical unit according to a comparative example of the present disclosure;
FIG. 7B is a cross-sectional view schematically illustrating a cross-section of a fifth example of a configuration of a reflective optical unit according to an embodiment of the present disclosure;
FIG. 8A is a cross-sectional view schematically illustrating a cross-section of a second example of a configuration of a reflective optical unit according to a comparative example of the present disclosure;
FIG. 8B is a cross-sectional view schematically illustrating a cross-section of a sixth example of a configuration of a reflective optical unit according to an embodiment of the present disclosure;
FIG. 9A is a cross-sectional view schematically illustrating a cross-section of a third example of a configuration of a reflective optical unit according to a comparative example of the present disclosure;
FIG. 9B is a cross-sectional view schematically illustrating a cross-section of a seventh example of a configuration of a reflective optical unit according to an embodiment of the present disclosure;
FIG. 10 is a schematic diagram illustrating an example of a configuration of a conventional transmissive optical rotary encoder;
FIG. 11 is a schematic diagram illustrating an example of a configuration of a conventional reflective optical rotary encoder;
FIG. 12A is a first schematic diagram for explaining a first problem in the conventional reflective optical rotary encoder;
FIG. 12B is a second schematic diagram for explaining the first problem in the conventional reflective optical rotary encoder; and
FIG. 13 is a schematic diagram for explaining a second problem in the conventional reflective optical rotary encoder.

### DETAILED DESCRIPTION

The background and problems with conventional techniques will now be described in more detail.

An encoder is known as a device that detects a mechanical amount of movement, direction, or angle. Encoders are broadly classified into magnetic and optical types. Optical encoders are further classified into transmissive and reflective types. Although a transmissive encoder is superior in terms of performance, a reflective encoder is advantageous in terms of cost and manufacturing. In recent years, the share of reflective encoders among optical encoders has been increasing.

An encoder is a device that converts a mechanical amount of movement, direction, or angle into an electrical signal. Encoders are broadly classified into linear encoders and rotary encoders. A rotary encoder is a sensor device that converts rotational motion into an electrical signal. Rotary encoders are used in a variety of machines or devices, such as industrial robots, machine tools, or elevators.

Rotary encoders include a transmissive rotary encoder, in which a light-emitting element and a light-receiving element are arranged opposite each other, and a code wheel that transmits/blocks light is inserted in the space between the light-emitting element and the light-receiving element. Rotary encoders also include a reflective rotary encoder, in which a light-emitting element and a light-receiving element are arranged on the same plane, and a code wheel that reflects/blocks light is arranged above the light-emitting element and the light-receiving element.

A reflective rotary encoder has a structure in which a light-emitting element and a light-receiving element are arranged on the same plane, and a code wheel that reflects or does not reflect light is installed thereabove. A reflective rotary encoder has the advantages that it can be easily made smaller or thinner, and also the assembly process can be simplified. Therefore, reflective rotary encoders are widely used in applications where space saving is particularly important, or in ultra-small actuators, collaborative robots, and the like.

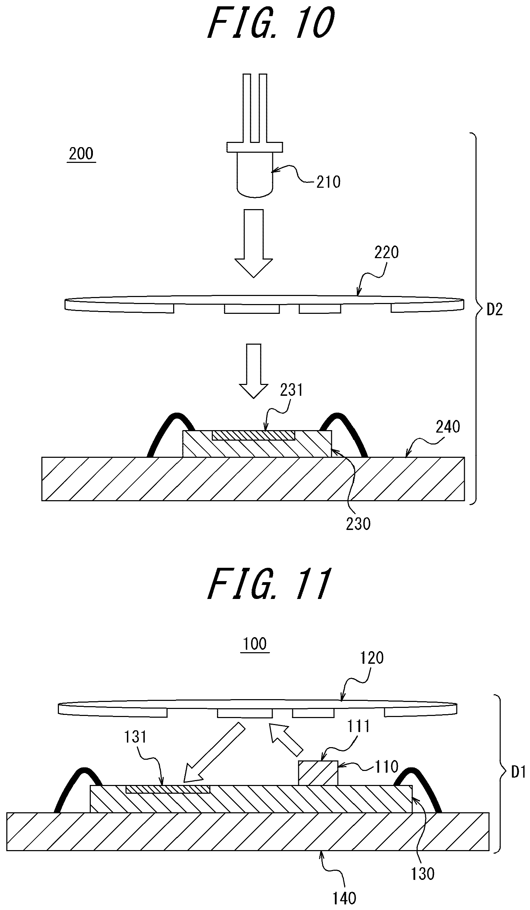

FIG. 10 is a schematic diagram illustrating an example of a configuration of a conventional transmissive optical rotary encoder 200. The optical rotary encoder 200 includes a light-emitting element 210, a code wheel 220, a light-receiving element 230, and a substrate 240. The light-receiving element 230 has a light-receiving surface 231 that receives the light emitted from the light-emitting element 210 and transmitted through the code wheel 220. The transmissive optical rotary encoder 200 has a uniform linear optical axis and therefore can support high resolution. However, the thickness D2 of the entire encoder, including the distance from the light-emitting element 210 to the substrate 240, becomes large. In addition, the light-emitting element 210, the code wheel 220, and the light-receiving element 230 must be aligned with one another.

FIG. 11 is a schematic diagram illustrating an example of a configuration of a conventional reflective optical rotary encoder 100. The optical rotary encoder 100 includes a light-emitting element 110, a code wheel 120, a light-receiving element 130, and a substrate 140. The light-receiving element 130 has a light-receiving surface 131 that receives the light emitted from the light-emitting element 110 and reflected by the code wheel 120. The reflective optical rotary encoder 100 can be made thinner. The thickness D1 of the entire encoder, from the code wheel 120 to the substrate 140, is small. On the other hand, the reflective structure has the following two problems.

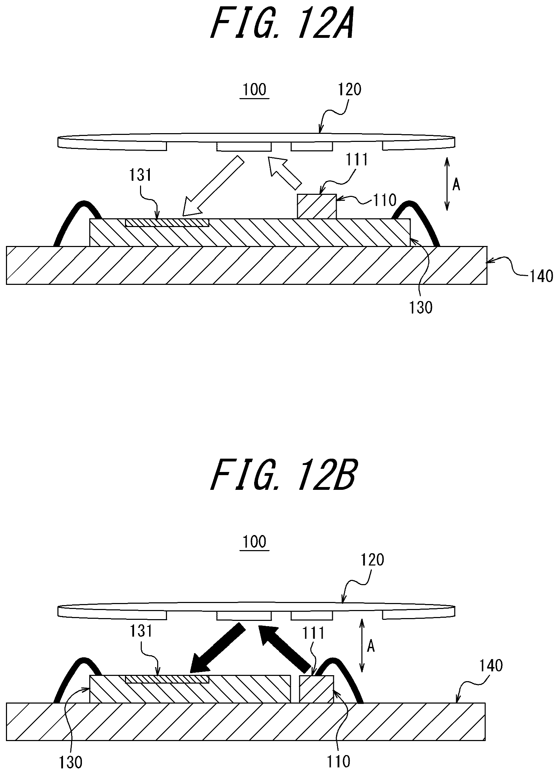

FIG. 12A is a first schematic diagram for explaining a first problem in the conventional reflective optical rotary encoder 100. FIG. 12B is a second schematic diagram for explaining the first problem in the conventional reflective optical rotary encoder 100. The first problem with the conventional reflective optical rotary encoder 100 will be described with reference to FIGS. 12A and 12B. The first problem is that the heights of the "light-emitting surface 111 of the light-emitting element 110" and the "light-receiving surface 131 of the light-receiving element 130" used in the reflective optical rotary encoder 100 must be matched.

For example, as illustrated in FIG. 12A, if the heights of the light-emitting surface 111 and the light-receiving surface 131 are significantly different from each other, the optical path length ratio changes according to the change in the distance A between the light-receiving element 130 and the code wheel 120. The "optical path length ratio" means, for example, the ratio of the optical path length between the light-emitting surface 111 and the code wheel 120 to the optical path length between the code wheel 120 and the light-receiving surface 131. When the optical path length ratio changes in accordance with a change in the distance A, the intensity, position, and incident angle of the light incident on the light-receiving surface 131 of the light-receiving element 130 all change, increasing the signal variation.

The change in distance A includes, for example, a change that occurs in each optical rotary encoder 100 due to individual differences among a plurality of optical rotary encoders 100 as products when the code wheel 120 is disposed in each of the optical rotary encoders 100. Alternatively, the change in distance A may include, for example, a change caused by the normal rotation of the code wheel 120 when the optical rotary encoder 100 is in use, or may include a change caused by external factors, such as external vibrations.

On the other hand, as illustrated in FIG. 12B, by making the optical path length between the light-emitting surface 111 and the code wheel 120 and the optical path length between the code wheel 120 and the light-receiving surface 131 a 1:1 ratio, the optical path length ratio remains 1 even if the distance A varies. As a result, the effect of variations in the distance A on the signal is reduced. That is, unlike the configuration illustrated in FIG. 12A, signal variations are reduced.

As described above, in order to address the first problem and stably realize a structure that brings the optical path length ratio close to 1, it is necessary to reduce the difference in height between the light-receiving surface 131 and the light-emitting surface 111, and to reduce the tolerance of this height difference.

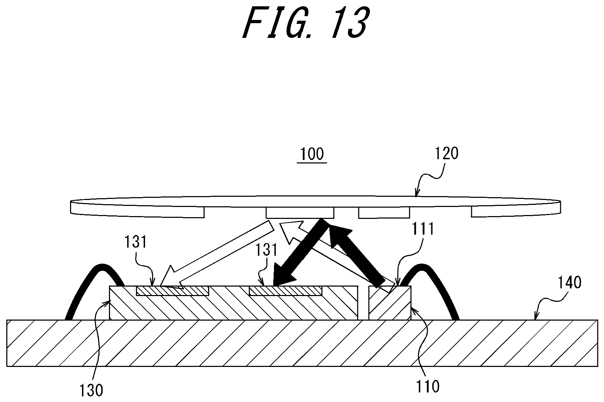

FIG. 13 is a schematic diagram for explaining a second problem in the conventional reflective optical rotary encoder 100. The second problem is that it is necessary to reduce the distance between the "light-emitting position of the light-emitting element 110" and the "light-receiving position of the light-receiving element 130". It is thought that the shorter the optical path length, that is, the closer the light-emitting position and the light-receiving position, the stronger the signal strength and the better the S/N ratio. In the case of a structure in which the light-emitting element 110 is installed adjacent to the light-receiving position of the light-receiving element 130, there is a concern that the optical path length will become longer at the light-receiving surface 131 that is farther away from the light-emitting element 110 side. As described above, in terms of the second problem, a reduction in the distance between the light-emitting position of the light-emitting element 110 and the light-receiving position of the light-receiving element 130 is required.

The present disclosure relates to a reflective optical unit 1 for an encoder that combines a light-emitting element 10 and a light-receiving element 30 and is used together with a reflector 20 as a code wheel, described below. The reflective optical unit 1 uses a light-emitting element 10 in the shape of a thin film, which can reduce the tolerance in the height direction and reduce signal variation. Additionally, the present disclosure relates to a reflective optical unit 1 that can increase signal strength by bringing the light-receiving position of the light-receiving element 30 and the light-emitting position of the light-emitting element 10 closer to each other. Furthermore, the present disclosure relates to a reflective optical unit 1 that can also avoid signal fluctuations caused by wires for driving the light-emitting element 10.

Embodiments of the present disclosure will be mainly described below with reference to the accompanying drawings. The numerical values of various parameters and the like in the following description are merely examples and do not limit the scope of the present disclosure in any way. The scope of the present disclosure should be determined solely by the claims.

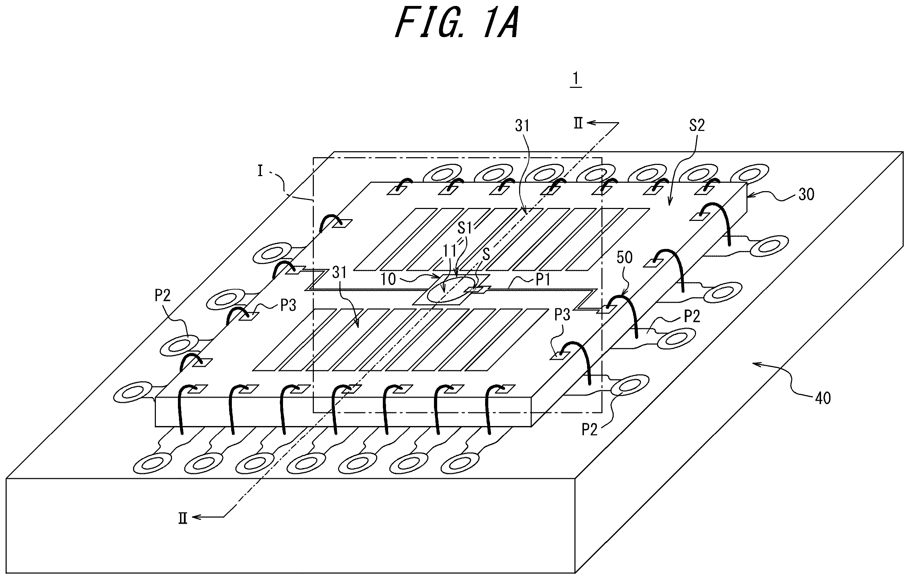

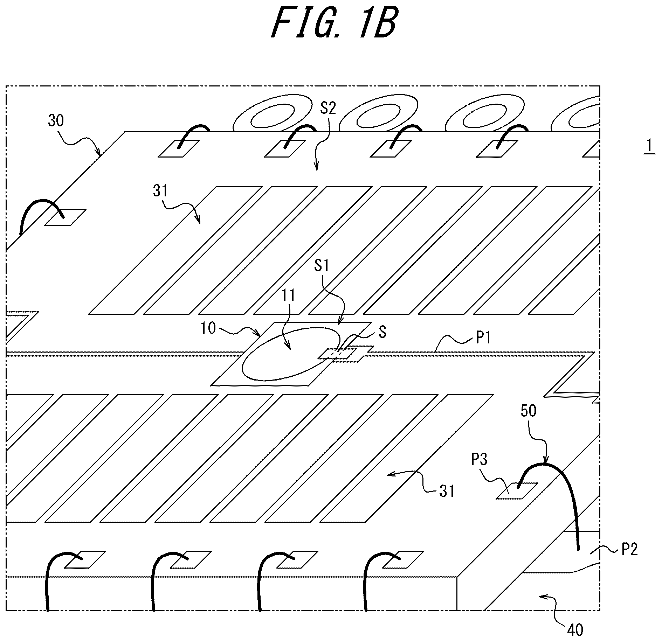

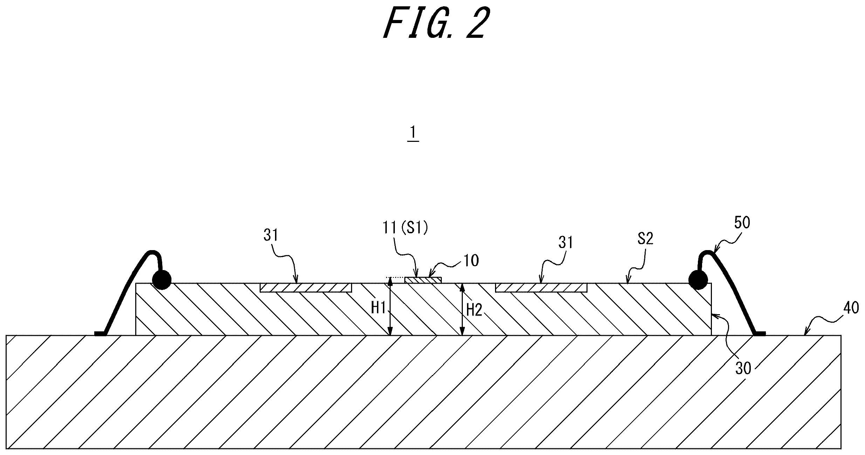

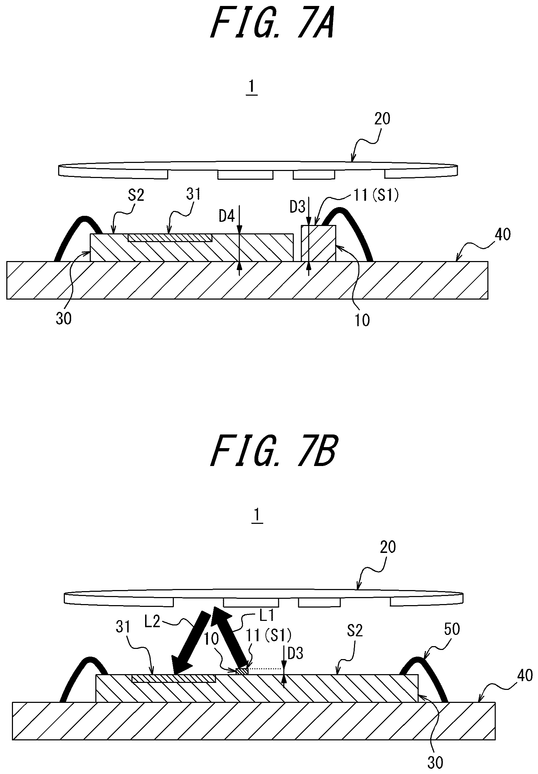

FIG. 1A is an external perspective view schematically illustrating a first example of the configuration of the reflective optical unit 1 according to an embodiment of the present disclosure. FIG. 1B is an enlarged view of the area enclosed by the dashed dotted line in FIG. 1A. FIG. 2 is a cross-sectional view schematically illustrating a cross-section taken along the line II-II of FIG. 1A. In FIGS. 1A to 2, the below-described reflector 20, included in the reflective optical unit 1, is not illustrated. The reflector 20 is illustrated in FIG. 7B, for example, among other figures. The first example of the configuration and functions of the reflective optical unit 1 according to an embodiment of the present disclosure will be mainly described with reference to FIGS. 1A to 2. The reflective optical unit 1 includes a reflector 20, a light-emitting element 10, a light-receiving element 30, a substrate 40, and wires 50.

The reflective optical unit 1 is used in, for example, an encoder. In the present disclosure, an "encoder" includes, for example, a device that converts a mechanical amount of movement, direction, or angle into an electrical signal. The encoder includes, for example, a rotary encoder. The rotary encoder is a sensor device that converts rotational motion into an electrical signal. The rotary encoder may be used in a variety of machines or devices, such as industrial robots, machine tools, or elevators. The rotary encoder may be, for example, an optical, reflective encoder. The encoder includes the reflective optical unit 1. In this case, the reflector 20 may include a code wheel.

The reflective optical unit 1 has, for example, a laminated structure. In the reflective optical unit 1, the light-emitting element 10 and the light-receiving element 30 are located on the substrate 40. In the reflective optical unit 1, the substrate 40, the light-receiving element 30, and the light-emitting element 10 may be stacked in this order. For example, the light-receiving element 30 may be located directly above the substrate 40. The light-emitting element 10 may further be located directly above the light-receiving element 30 that is located directly above the substrate 40. In the reflective optical unit 1, light is emitted from the light-emitting element 10 toward the reflector 20, illustrated in FIG. 7B and other figures, which is located on the opposite side from the substrate 40. Light from the light-emitting element 10 is reflected by the reflector 20 and detected by the light-receiving element 30 located on the same side of the reflector 20 as the light-emitting element 10.

The concept of the reflective optical unit 1 is for a "light-emitting element 10 with a thin-film shape (and narrow light-emitting region)" to be mounted "near a light-receiving surface 31 of the light-receiving element 30", instead of a conventional light-emitting element that generally has a height of 150 µm to 300 µm. The reflective optical unit 1 is, for example, configured so that the light-emitting element 10 is shaped as a thin film of 10 µm or less in thickness, has a light-emitting region of less than 200 µm in width, and is positioned to have a short distance to the light-receiving surface 31 of the light-receiving element 30. In the reflective optical unit 1, the center of a plurality of light-receiving surfaces 31 is selected as a candidate for the position of the light-emitting element 10 so that light is efficiently incident on all of the plurality of light-receiving surfaces 31.

The light-emitting element 10 includes, for example, a light-emitting diode (LED) element or a laser diode (LD) element. The LED includes, for example, a micro-LED or a thin-film point source LED. The LD includes, for example, a vertical cavity surface emitting laser (VCSEL) formed as a thin film. The light-emitting element 10 irradiates the reflector 20 with light having any wavelength for which the light-receiving element 30 has a high light-receiving sensitivity and that can be used for signal processing by the encoder. For example, the light-emitting surface 11 of the light-emitting element 10 is included in a first surface S1, which faces away from the substrate 40, in the light-emitting element 10.

The light-emitting element 10 has a thin-film shape. In the present disclosure, the term "thin-film shape" includes, for example, a shape that is thin enough to be considered a film. Thin-film shapes may include shapes with a thickness of, for example, 20 µm or less. The light-emitting element 10 may have a thickness that is, for example, 5 % or less, more preferably 3 % or less, and even more preferably 1 % or less of the first optical path length between the light-emitting surface 11 and the reflecting surface of the reflector 20. The thickness of the light-emitting element 10 may be, for example, in the range of 20 µm or less. The thickness of the light-emitting element 10 may preferably be in the range of 0.5 µm to 20 µm, more preferably in the range of 1 µm to 20 µm, and even more preferably in the range of 1 µm to 10 µm.

The light-emitting element 10 may be configured to have the thickness of a thin film while the width of the light-emitting surface 11 associated with the light-emitting region is approximately several hundred µm. As illustrated in FIGS. 1A and 1B, the light-emitting element 10 may have a rectangular shape, such as a square shape, with two sides each measuring approximately several hundred micrometers overall. The light-emitting element 10 is disposed, for example, at the center of a second surface S2 of the light-receiving element 30, facing away from the substrate 40. The light-emitting element 10 is positioned between two adjacent rows of a plurality of light-receiving surfaces 31 arranged in rows. A plurality of light-receiving surfaces 31 are arranged in a row on each side of the light-emitting element 10.

An edge portion of the light-emitting element 10 and a circuit pattern P1 located on a second surface S2 of the light-receiving element 30 are electrically connected directly via a conductive material S without using the wire 50. In the present disclosure, the "conductive material S" includes, for example, solder or a thin-film electrode material (for example, an Au film or an ITO film) formed together with an insulating film. Since the light-emitting element 10 having a thin-film shape is located at approximately the same height as the circuit pattern P1 located on the second surface S2, the edge portion of the light-emitting element 10 can be directly mounted to the circuit pattern P1 using the conductive material S, for example, by soldering or by forming a thin-film electrode material (e.g., an Au film or an ITO film) formed together with an insulating film. The light-emitting element 10 is electrically connected directly to one end of the circuit pattern P1 by the conductive material S and is indirectly connected from the other end of the circuit pattern P1 to the circuit pattern P2 on the substrate 40 via the wire 50. In this way, electrical connection between the light-emitting element 10 and the substrate 40 is achieved. The conductive material S is illustrated only in FIGS. 1A and 1B and is omitted from the other figures for the sake of simplicity.

The light-receiving element 30 includes, for example, any detection element that can detect light that is emitted from the light-emitting element 10 and reflected by the reflector 20. The detection element includes, for example, a photodiode (PD). The photodiode includes, for example, a silicon (Si) PD. The light-receiving element 30 has a predetermined light-receiving sensitivity to the wavelength of the light emitted from the light-emitting element 10, converts the light into an electrical signal, and outputs the electrical signal required for signal processing by the encoder. For example, the light-receiving surface 31 of the light-receiving element 30 is included in the second surface S2, which faces away from the substrate 40, in the light-receiving element 30.

The light-receiving element 30 may be configured so that the width of the light-receiving surface 31 associated with the light-receiving region is approximately several hundred µm. The light-receiving surface 31 of the light-receiving element 30 may have a rectangular shape, for example, with two sides each measuring approximately several hundred micrometers overall. The light-receiving surface 31 of the light-receiving element 30 may be disposed relative to the light-emitting element 10 so that the side adjacent to the light-emitting element 10 is the short side and the side orthogonal to the short side is the long side.

The light-receiving element 30 may have a plurality of light-receiving surfaces 31 on the second surface S2. For example, the light-receiving element 30 may have a plurality of light-receiving surfaces 31 arranged in a line on both sides of the light-emitting element 10, which is arranged in the center of the second surface S2. As illustrated in FIG. 2, the pair of light-receiving surfaces 31 arranged on both sides of the light-emitting element 10 may be arranged symmetrically in the left-right direction with respect to the light-emitting element 10. For example, the distance to the light-emitting element 10 from the light-receiving surface 31 located on one side of the light-emitting element 10 may be the same as the distance to the light-emitting element 10 from the light-receiving surface 31 located on the other side of the light-emitting element 10.

The difference between a first height H1 of the first surface S1 of the light-emitting element 10 relative to the substrate 40, the first surface S1 facing away from the substrate 40, and a second height H2 of the second surface S2 of the light-receiving element 30 relative to the substrate 40, the second surface S2 facing away from the substrate 40, is equal to or less than the thickness of the light-emitting element 10. For example, as illustrated in FIG. 2, when the light-emitting element 10 is disposed directly on the second surface S2 of the light-receiving element 30, the difference between the first height H1 and the second height H2 is the same as the thickness of the light-emitting element 10. If the thickness of the light-emitting element 10 is 10 µm, the difference is 10 µm.

The tolerance of the difference between the first height H1 and the second height H2 is, for example, in the range of 0 µm to 5 µm. The tolerance of the difference may more preferably be in the range of 0 µm to 3 µm and even more preferably in the range of 0 µm to 1 µm. For example, in a case in which the thickness of the light-emitting element 10 is 10 µm, the difference may be in the range of 5 µm to 15 µm depending on the individual differences among a plurality of encoders as products when the reflective optical unit 1 is placed in each of the encoders.

As illustrated in FIGS. 1A and 1B, the light-receiving element 30 has, in addition to the above-described circuit pattern P1 that is electrically connected to the edge portion of the light-emitting element 10 via the conductive material S, a plurality of circuit patterns P3 that are arranged to surround the periphery of the plurality of light-receiving surfaces 31 at the edge portion of the light-receiving element 30. Each of the circuit patterns P3 is electrically connected to a circuit pattern P2 on the substrate 40 via a wire 50. This achieves electrical connection between the light-receiving element 30 and the substrate 40.

The substrate 40 includes, for example, any member that supports the light-emitting element 10 and the light-receiving element 30 and realizes electrical connection to each element. The substrate 40 includes, for example, a printed circuit board (PCB) that is easy to process and mount. Wiring patterns, electrodes, and the like are arranged on the surface of the substrate 40. For example, a plurality of circuit patterns P2 is arranged on the surface of the substrate 40. One of the plurality of circuit patterns P2 is electrically connected to the light-emitting element 10 via the wire 50, the circuit pattern P1, and the conductive material S, as described above. A plurality of the circuit patterns P2 is electrically connected to the circuit pattern P3 of the light-receiving element 30 via the wires 50, as described above.

The wire 50 includes, for example, wire made of any conductive material. The material includes, for example, gold (Au), silver (Ag), or copper (Cu). The wire 50 may include, for example, an Au wire. The wire 50 is used, for example, when it is difficult to directly electrically connect the circuit pattern P3 of the light-receiving element 30, which has a predetermined thickness unlike the light-emitting element 10 that has a thin-film shape, to the circuit pattern P2 of the substrate 40 using the conductive material S. In a case in which the distance between the circuit pattern P3 of the light-receiving element 30 and the circuit pattern P2 of the substrate 40 is large, the wire 50 is disposed across that distance and serves to electrically connect the patterns to each other.

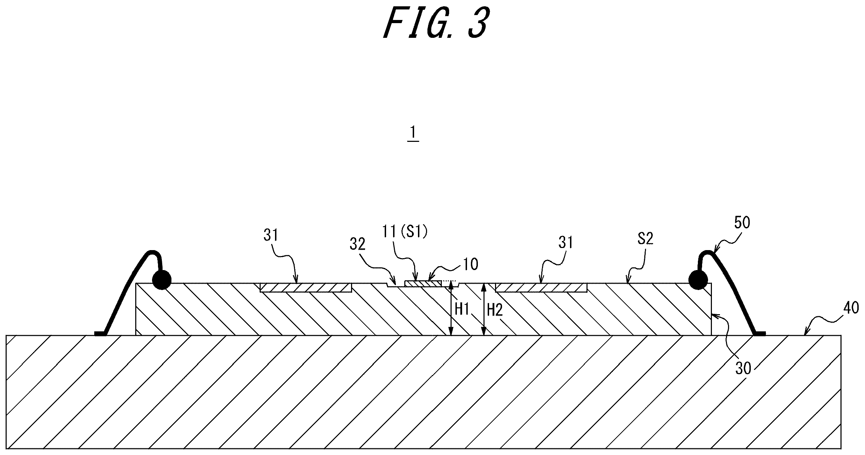

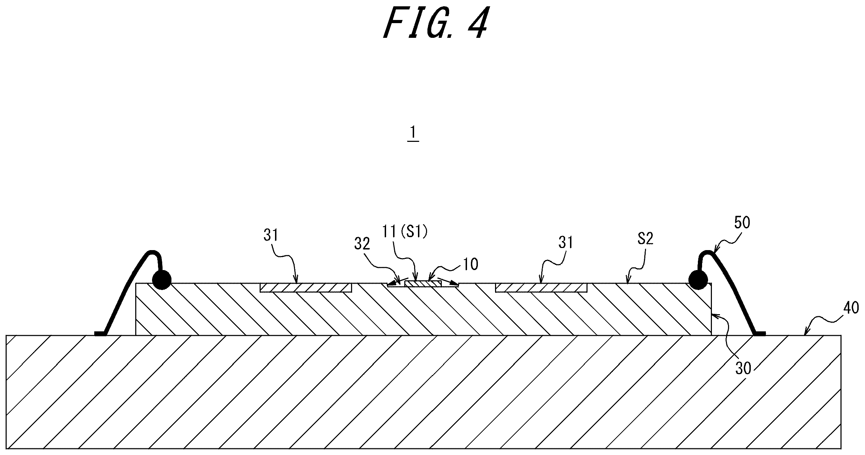

FIG. 3 is a first cross-sectional view schematically illustrating a cross-section of a second example of the configuration of the reflective optical unit 1 according to an embodiment of the present disclosure. FIG. 4 is a second cross-sectional view schematically illustrating a cross-section of the second example of the configuration of the reflective optical unit 1 according to an embodiment of the present disclosure. The cross-sectional views of FIGS. 3 and 4 each correspond to the cross-sectional view of FIG. 2. In FIGS. 3 and 4, the below-described reflector 20, included in the reflective optical unit 1, is not illustrated. The reflector 20 is illustrated in FIG. 7B, for example, among other figures. The second example of the configuration and functions of the reflective optical unit 1 according to an embodiment of the present disclosure will be mainly described with reference to FIGS. 3 and 4.

In the first example described above, the light-emitting element 10 is disposed on the flat portion of the second surface S2 of the light-receiving element 30, but the shape of the second surface S2 on which the light-emitting element 10 is disposed is not limited to a flat shape. For example, the light-receiving element 30 may have a recess 32 in the second surface S2 in which the light-emitting element 10 is disposed. That is, the shape of the second surface S2 on which the light-emitting element 10 is arranged may be a concave shape.

The recess 32 may, for example, have any depth such that the difference between the first height H1 of the first surface S1 relative to the substrate 40 and the second height H2 of the second surface S2 relative to the substrate 40 is equal to or less than the thickness of the light-emitting element 10. For example, the recess 32 may be configured to have a depth that is two times or less the thickness of the light-emitting element 10. When the recess 32 is configured to have the same depth as the thickness of the light-emitting element 10, the light-emitting surface 11 included in the first surface S1 and the light-receiving surface 31 included in the second surface S2 are at the same height relative to the substrate 40. For example, the light-emitting element 10 may be disposed in a recess 32 that is a depression having a depth equal to the thickness of the light-emitting element 10.

As described above, the tolerance of the difference between the first height H1 and the second height H2 is, for example, within the range of 0 µm to 5 µm. For example, when the thickness of the light-emitting element 10 is 10 µm and the recess 32 is configured to have the same depth as the thickness of the light-emitting element 10, the difference between the first height H1 and the second height H2 may be in the range of +5 µm to -5 µm depending on the individual differences among a plurality of encoders as products when the reflective optical unit 1 is placed in each the encoders.

As illustrated in FIG. 4, when the light-emitting element 10 is placed in the recess 32, the periphery of the light-emitting surface 11 is surrounded by the edge of the recess 32. Therefore, by processing the recess 32 on the second surface S2 of the light-receiving element 30 as illustrated in FIGS. 3 and 4, the intensity of the light, among light emitted from the light-emitting element 10, that is directly incident on the light-receiving surface 31 from the light-emitting element 10 without being reflected by the reflector 20 is reduced.

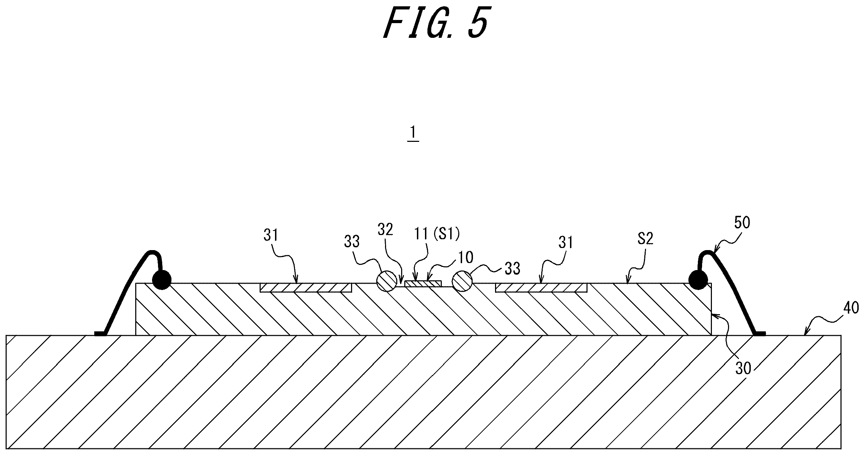

FIG. 5 is a cross-sectional view schematically illustrating a cross-section of a third example of the configuration of the reflective optical unit 1 according to an embodiment of the present disclosure. The cross-sectional view of FIG. 5 corresponds to the cross-sectional view of FIG. 2. In FIG. 5, the below-described reflector 20, included in the reflective optical unit 1, is not illustrated. The reflector 20 is illustrated in FIG. 7B, for example, among other figures. The third example of the configuration and functions of the reflective optical unit 1 according to an embodiment of the present disclosure will be mainly described with reference to FIG. 5.

The reflective optical unit 1 may further include a guard 33 made of light-blocking resin and arranged at the corner of the recess 32 of the light-receiving element 30. The guard 33 may be disposed so as to surround the periphery of the light-emitting element 10 disposed in the recess 32. Therefore, by processing the recess 32 on the second surface S2 of the light-receiving element 30 as illustrated in FIG. 5 and providing the light-blocking resin guard 33, the intensity of the light, among light emitted from the light-emitting element 10, that is directly incident on the light-receiving surface 31 from the light-emitting element 10 without being reflected by the reflector 20 is further reduced.

The guard 33 may be used in combination with the recess 32 arranged on the second surface S2 of the light-receiving element 30 as in the third example or may be used alone without being combined with the recess 32. For example, the guard 33 may be arranged to surround the light-emitting element 10 when no recess 32 is formed on the second surface S2 and the light-emitting element 10 is arranged on a flat portion of the second surface S2.

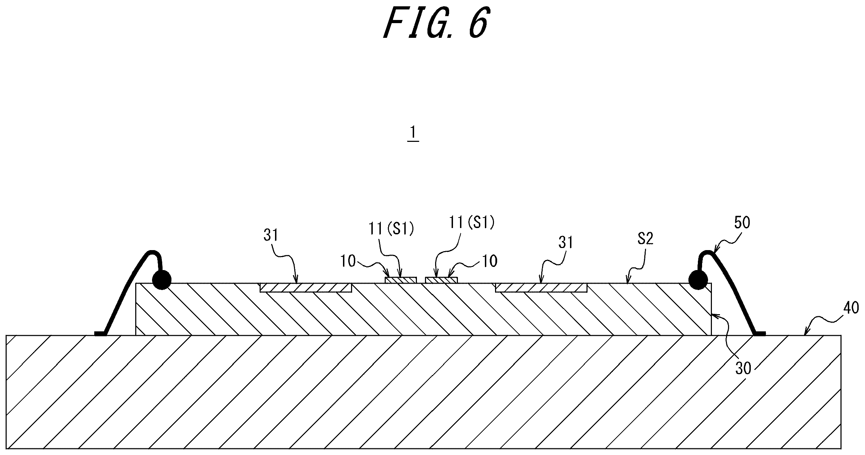

FIG. 6 is a cross-sectional view schematically illustrating a cross-section of a fourth example of the configuration of the reflective optical unit 1 according to an embodiment of the present disclosure. The cross-sectional view of FIG. 6 corresponds to the cross-sectional view of FIG. 2. In FIG. 6, the below-described reflector 20, included in the reflective optical unit 1, is not illustrated. The reflector 20 is illustrated in FIG. 7B, for example, among other figures. The fourth example of the configuration of the reflective optical unit 1 according to an embodiment of the present disclosure will be mainly described with reference to FIG. 6.

In the first to third examples of configurations, only a single light-emitting element 10 is arranged on the second surface S2 of the light-receiving element 30, but these examples are not limiting. A plurality of light-emitting elements 10 may be arranged on the second surface S2 of the light-receiving element 30. In this case, the plurality of light-emitting elements 10 included in the reflective optical unit 1 may be in close proximity to each other. In FIG. 6, as an example, two light-emitting elements 10 are arranged in close proximity to each other on the second surface S2. For example, the distance between the two light-emitting elements 10 may be about several tens of µm.

FIG. 7A is a cross-sectional view schematically illustrating a cross-section of a first example of the configuration of a reflective optical unit 1 according to a comparative example of the present disclosure. FIG. 7B is a cross-sectional view schematically illustrating a cross-section of a fifth example of the configuration of the reflective optical unit 1 according to an embodiment of the present disclosure. The cross-sectional views of FIGS. 7A and 7B correspond to the cross-sectional view of FIG. 2. In FIGS. 7A and 7B, the reflector 20 included in the reflective optical unit 1 is clearly illustrated. The fifth example of the configuration and functions of the reflective optical unit 1 according to an embodiment of the present disclosure will be mainly described with reference to FIGS. 7A and 7B.

As illustrated in FIG. 7B, the reflector 20 is, for example, a code wheel. The reflector 20 is located on the opposite side from the substrate 40 with respect to the light-emitting element 10 and the light-receiving element 30. The reflector 20 is disposed so as to face the light-emitting surface 11 of the light-emitting element 10 and the light-receiving surface 31 of the light-receiving element 30. The reflector 20 is arranged so as to be rotatable around a central axis.

The reflector 20 reflects the light emitted from the light-emitting surface 11 of the light-emitting element 10 toward the light-receiving surface 31 of the light-receiving element 30. The first optical path length L1 between the light-emitting surface 11 included in the first surface S1 of the light-emitting element 10 and the reflecting surface of the reflector 20 and the second optical path length L2 between the light-receiving surface 31 included in the second surface S2 of the light-receiving element 30 and the reflecting surface of the reflector 20 are illustrated in FIG. 7B. The error between the first optical path length L1 and the second optical path length L2 is, for example, in the range of 0 % to 5 %. The error between the first optical path length L1 and the second optical path length L2 may more preferably be in the range of 0 % to 3 % and even more preferably in the range of 0 % to 1 %.

The error between the first optical path length L1 and the second optical path length L2 means, for example, the ratio of the difference between the first optical path length L1 and the second optical path length L2 to the first optical path length L1 or the second optical path length L2. The error between the first optical path length L1 and the second optical path length L2 may indicate, for example, how much the first optical path length L1 deviates from the second optical path length L2 due to the thickness D3 of the light-emitting element 10. For example, the smaller the thickness D3 of the light-emitting element 10 is relative to the first optical path length L1 and the second optical path length L2, the smaller the error between the first optical path length L1 and the second optical path length L2.

The light-emitting element 10 has, for example, a thickness D3 that is small enough to be considered as a film with respect to each of the first optical path length L1 and the second optical path length L2. For example, in a case in which the thickness D3 of the light-emitting element 10 having a thin-film shape is 10 µm and each of the first optical path length L1 and the second optical path length L2 is approximately several hundred µm to 1 mm, the light-emitting element 10 may have a thickness D3 that is, for example, 5 % or less of each of the first optical path length L1 and the second optical path length L2. The light-emitting element 10 can be regarded as a film that is sufficiently thin with respect to each of the optical path lengths, which are, for example, several hundred µm to 1 mm.

As can be seen by comparing FIGS. 7A and 7B, the reflective optical unit 1 reduces the tolerance of the difference in height between the light-emitting surface 11 of the light-emitting element 10 and the light-receiving surface 31 of the light-receiving element 30. For example, consider a structure in which the light-emitting element 10 is disposed next to the light-receiving element 30 in the comparative example illustrated in FIG. 7A. In this case, the difference in height between the light-emitting surface 11 of the light-emitting element 10 and the light-receiving surface 31 of the light-receiving element 30 is affected by the tolerances of both the thickness D3 of the light-emitting element 10 and the thickness D4 of the light-receiving element 30. For example, assuming that the thickness of each of the light-emitting element 10 and the light-receiving element 30 is approximately 200 µm, even with a tolerance of 10 %, a difference of 20 µm × 2 = 40 µm may occur in the above-described difference.

On the other hand, in the reflective optical unit 1 according to an embodiment illustrated in FIG. 7B, the light-emitting element 10 is disposed on the second surface S2 of the light-receiving element 30 and has a thin-film shape, resulting in a small thickness D3. Therefore, the heights of the light-emitting surface 11 of the light-emitting element 10 and the light-receiving surface 31 of the light-receiving element 30 are approximately the same. The light-emitting surface 11 that does not contact the substrate 40 in the light-emitting element 10 and the light-receiving surface 31 of the light-receiving element 30 that does not contact the substrate 40 are positioned on approximately the same plane. That is, the light-emitting surface 11 and the light-receiving surface 31 are located at approximately the same height.

Furthermore, since the thickness D3 of the light-emitting element 10 is small, the tolerance of the thickness D3 of the light-emitting element 10 is also small. For example, assuming that the thickness of the light-emitting element 10 is about 10 µm, a tolerance of 10 % results in a difference of 1 µm. As described above, the difference in height between the light-emitting surface 11 of the light-emitting element 10 and the light-receiving surface 31 of the light-receiving element 30 is affected only by the small tolerance of the thickness D3 of the light-emitting element 10. As a result, the tolerance of the difference also becomes smaller. As mentioned above, the tolerance of the difference may be, for example, in the range of 0 µm to 5 µm.

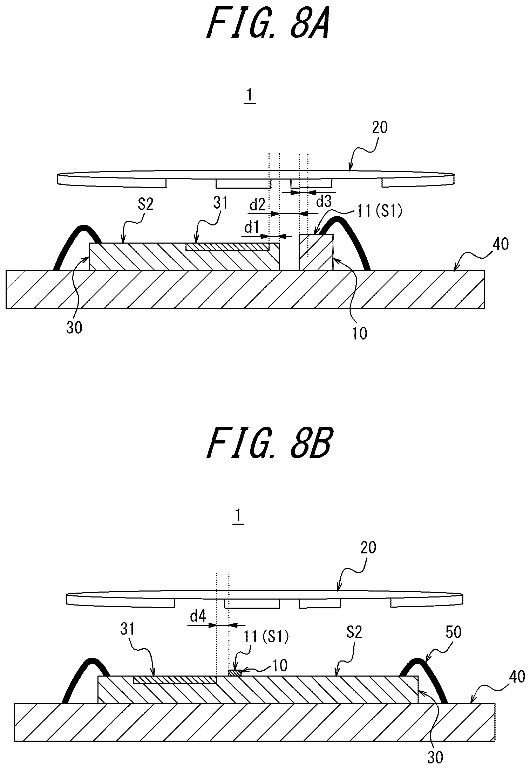

FIG. 8A is a cross-sectional view schematically illustrating a cross-section of a second example of the configuration of the reflective optical unit 1 according to a comparative example of the present disclosure. FIG. 8B is a cross-sectional view schematically illustrating a cross-section of a sixth example of the configuration of the reflective optical unit 1 according to an embodiment of the present disclosure. The cross-sectional views of FIGS. 8A and 8B correspond to the cross-sectional view of FIG. 2. In FIGS. 8A and 8B, the reflector 20 included in the reflective optical unit 1 is clearly illustrated. The sixth example of the configuration and functions of the reflective optical unit 1 according to an embodiment of the present disclosure will be mainly described with reference to FIGS. 8A and 8B.

As can be seen by comparing FIGS. 8A and 8B, the reflective optical unit 1 reduces the distance between the light-emitting surface 11 of the light-emitting element 10 and the light-receiving surface 31 of the light-receiving element 30, thereby improving the signal strength of the electrical signal required for the encoder. For example, consider a structure in which the light-emitting element 10 is disposed next to the light-receiving element 30 in the comparative example illustrated in FIG. 8A. At this time, the light-receiving surface 31 of the light-receiving element 30 and the light-emitting surface 11 of the light-emitting element 10 are separated by a distance equal to the sum of a first distance d1 from the end of the light-receiving surface 31 to the end of the light-receiving element 30, a second distance d2 between the light-receiving element 30 and the light-emitting element 10, and a third distance d3 from the end of the light-emitting element 10 to the end of the light-emitting surface 11. Assuming that the first distance d1 is 100 µm, the second distance d2 is 150 µm, and the third distance d3 is 50 µm, the distance between the light-receiving surface 31 and the light-emitting surface 11 is 300 µm.

On the other hand, in the reflective optical unit 1 according to an embodiment illustrated in FIG. 8B, the light-emitting element 10 has a thin-film shape, and the light-emitting surface 11 can be arranged over nearly the entire thin film of the light-emitting element 10. In addition, the light-emitting element 10 can be disposed directly above the light-receiving element 30 and in the vicinity of the light-receiving surface 31. Therefore, a fourth distance d4 between the light-receiving surface 31 of the light-receiving element 30 and the light-emitting surface 11 of the light-emitting element 10 can be 100 µm or less. In the reflective optical unit 1, since the fourth distance d4 between the light-emitting surface 11 of the light-emitting element 10 and the light-receiving surface 31 of the light-receiving element 30 is small, it is possible to bring these surfaces closer together and increase the amount of light incident at the light-receiving surface 31 among the light arriving from the light-emitting surface 11 via the reflector 20. As a result, the reflective optical unit 1 improves the signal strength of the electrical signal required for the encoder.

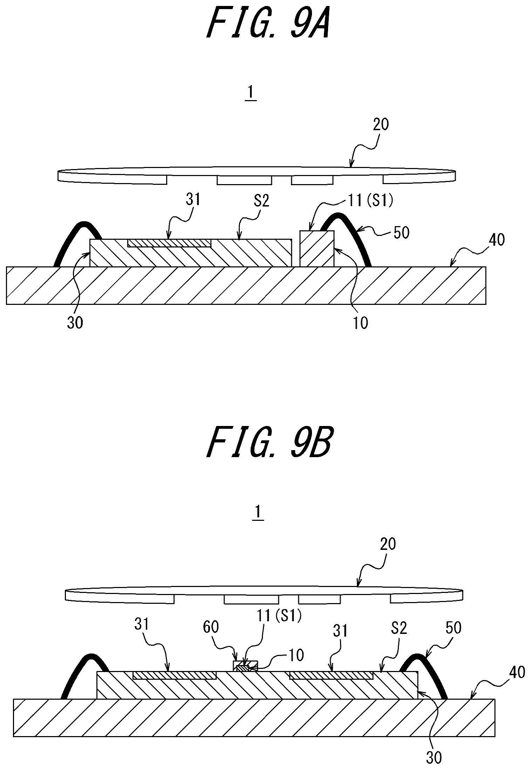

FIG. 9A is a cross-sectional view schematically illustrating a cross-section of a third example of the configuration of the reflective optical unit 1 according to a comparative example of the present disclosure. FIG. 9B is a cross-sectional view schematically illustrating a cross-section of a seventh example of the configuration of the reflective optical unit 1 according to an embodiment of the present disclosure. The cross-sectional views of FIGS. 9A and 9B correspond to the cross-sectional view of FIG. 2. In FIGS. 9A and 9B, the reflector 20 included in the reflective optical unit 1 is clearly illustrated. The seventh example of the configuration and functions of the reflective optical unit 1 according to an embodiment of the present disclosure will be mainly described with reference to FIGS. 9A and 9B.

As can be seen by comparing FIGS. 9A and 9B, the reflective optical unit 1 does not require wiring for the light-emitting element 10, and it is also possible to avoid the shadow of the wire 50 being cast on the light-emitting surface 11 of the light-emitting element 10. For example, consider a structure in which the light-emitting element 10 is disposed next to the light-receiving element 30 in the comparative example illustrated in FIG. 9A. At this time, the light-emitting surface 11 of the light-emitting element 10 is separated from the substrate 40 by a certain height. Therefore, for example, a wire 50 is required as wiring for electrically connecting the light-emitting element 10 to the substrate 40. To prevent the wire 50 from casting a shadow, the wire 50 needs to be disposed outside the light-emitting surface 11, which is the light-emitting region of the light-emitting element 10, and on the opposite side from the light-receiving element 30.

On the other hand, in the reflective optical unit 1 according to the embodiment illustrated in FIG. 9B, the light-emitting element 10 has a thin-film shape and is thus very thin. Therefore, in the reflective optical unit 1, wiring using a transparent electrode 60 instead of the wire 50 can be realized after the light-emitting element 10 is mounted. At this time, the light-emitting element 10 is electrically connected to the circuit pattern P1 located on the second surface S2 of the light-receiving element 30, for example, as illustrated in FIGS. 1A and 1B, by the transparent electrode 60 covering the entire surface of the light-emitting element 10. This allows the reflective optical unit 1 to eliminate the effect of the wire 50 on the light-emitting surface 11 of the light-emitting element 10 and to arrange the light-receiving surfaces 31 on both sides of the light-emitting element 10. The reflective optical unit 1 can also avoid signal fluctuations caused by the wire 50 for driving the light-emitting element 10.

As described above, the configuration of the present disclosure includes the following plurality of characteristic processes.

First, the reflective optical unit 1 uses the "thin-film shaped light-emitting element 10." By use of the "thin-film shaped light-emitting element 10", the second surface S2 of the light-receiving element 30 and the first surface S1 of the light-emitting element 10 are located on approximately the same plane. As a result, the reflective optical unit 1 can maintain a relationship of approximately 1:1 between the first optical path length L1 and the second optical path length L2 even if the position of the reflector 20, which is the code wheel, moves slightly up and down relative to the substrate 40. For example, the error between the first optical path length L1 and the second optical path length L2 is in the range of 0 % to 5 %. Therefore, the reflective optical unit 1 can also reduce the effect of errors and other factors on the electrical signal. The reflective optical unit 1 can reduce signal variations.

Second, the reflective optical unit 1 defines a light-emitting position and a light-receiving position. The shorter the optical path length between the reflector 20, which is the code wheel, and each of the light-emitting surface 11 of the light-emitting element 10 and the light-receiving surface 31 of the light-receiving element 30, the stronger the signal strength of the electrical signal, improving the reliability of measurements in the encoder. The reflective optical unit 1 can improve the signal strength of the electrical signal by reducing the distance between the light-emitting surface 11 of the light-emitting element 10 and the light-receiving surface 31 of the light-receiving element 30.

Third, the reflective optical unit 1 defines the height tolerance of the light-emitting element 10 and the light-receiving element 30. For example, by positioning the light-emitting element 10 directly above the light-receiving element 30, the tolerance in the height direction of the light-receiving element 30 does not affect the difference in height between the light-receiving surface 31 and the light-emitting surface 11. In this case, only the tolerance in the height direction of the light-emitting element 10 affects the difference in height. In order to achieve higher accuracy measurements than with conventional technology, the reflective optical unit 1 can reduce the difference, and tolerance thereof, between the first height H1 of the first surface S1 relative to the substrate 40 and the second height H2 of the second surface S2 relative to the substrate 40, thereby reducing signal variation.

While the height of a conventional light-emitting element is approximately 200 µm, the height (thickness D3) of the light-emitting element 10 of the reflective optical unit 1 according to an embodiment of the present disclosure is, for example, in the range of 0.5 µm to 20 µm. Therefore, it is expected that the tolerance in the height direction of the light-emitting element 10 will be sufficiently small compared to that of a conventional light-emitting element. In view of this, the reflective optical unit 1 is capable of reducing the tolerance of the difference between the first height H1 of the first surface S1 relative to the substrate 40 and the second height H2 of the second surface S2 relative to the substrate 40 as compared to conventional configurations. For example, the tolerance of the difference may be in the range of 0 µm to 5 µm.

Fourth, the reflective optical unit 1 eliminates the need for wiring in the light-emitting element 10. The reflective optical unit 1 uses the light-emitting element 10 with a thin-film shape and therefore does not require direct connection of the wire 50 to the light-emitting element 10. Alternatively, the edge portion of the light-emitting element 10 and the circuit pattern P1 located on the second surface S2 may be electrically connected directly via the conductive material S without using the wire 50. The light-emitting element 10 may also be electrically connected to the circuit pattern P1 located on the second surface S2 by the transparent electrode 60 that covers the entire surface of the light-emitting element 10.

As a result of the above, the wire 50 does not block the light emitted from the light-emitting element 10, and the reflective optical unit 1 allows the light-receiving surface 31 to be arranged in any direction centered on the light-emitting element 10 while reducing degradation of the electrical signal. In the reflective optical unit 1, light-receiving surfaces 31 can also be arranged on both sides of the light-emitting element 10 without the wire 50 affecting the light-emitting state of the light-emitting element 10. The reflective optical unit 1 can receive light through these light-receiving surfaces 31 without the wire 50 affecting the light-emitting state of the light-emitting element 10.

As illustrated in FIGS. 3 and 4, the light-receiving element 30 has a recess 32, in the second surface S2, in which the light-emitting element 10 is disposed. As a result, by additionally processing the recess 32 on the second surface S2, the reflective optical unit 1 can further reduce the difference in height between the light-receiving surface 31 and the light-emitting surface 11. Additionally, the reflective optical unit 1 can reduce the direct incidence of light from the light-emitting surface 11 of the light-emitting element 10 onto the light-receiving surface 31 by processing the recess 32. This effect becomes more pronounced with the light-blocking resin guard 33 arranged around the light-emitting element 10.

It will be apparent to those skilled in the art that the present disclosure may be realized in certain forms other than the above embodiments without departing from the spirit or essential characteristics of the present disclosure. Accordingly, the foregoing description is merely illustrative and is not limiting. The scope of the disclosure is defined by the appended claims, not by the foregoing description. Among all modifications, those within a range of equivalents to the present disclosure shall be considered as being included in the present disclosure.

For example, the shape, pattern, size, arrangement, orientation, type, and number of each component described above are not limited to those illustrated in the above description and the drawings. The shape, pattern, size, arrangement, orientation, type, and number of each component may be configured in any way that can achieve the corresponding function. Each component of the illustrated reflective optical unit 1 is a functional concept. The specific form of each component is not limited to that illustrated in the drawings.

In the above embodiment, the tolerance of the difference between the first height H1 and the second height H2 has been described as being within the range of 0 µm to 5 µm, but this configuration is not limiting. The tolerance of the difference may be in a range of more than 5 µm.

In the above embodiment, the reflective optical unit 1 has been described as having a reflector 20 that reflects light emitted from the light-emitting surface 11 of the light-emitting element 10 toward the light-receiving surface 31 of the light-receiving element 30, but this configuration is not limiting. The reflector 20 of the encoder does not have to constitute a part of the reflective optical unit 1. That is, the reflective optical unit 1 itself does not need to include the reflector 20. The encoder may include a reflective optical unit 1 and a reflector 20 that is a separate component from the reflective optical unit 1.

In the above embodiment, the error between the first optical path length L1 and the second optical path length L2 has been described as being within the range of 0 % to 5 %, but this configuration is not limiting. The error may be in a range of more than 5 %.

In the above embodiment, the light-emitting element 10 has been described as being located directly above the light-receiving element 30, but this configuration is not limiting. The light-emitting element 10 and the light-receiving element 30 may have any other arrangement relationship as long as they are arranged on the substrate 40. For example, the light-emitting element 10 and the light-receiving element 30 may both be located directly above the substrate 40. In this case, the light-receiving element 30 may have a thin-film shape similar to the light-emitting element 10.

In the above embodiment, the edge portion of the light-emitting element 10 and the circuit pattern P1 located on the second surface S2 have been described as being electrically connected directly via the conductive material S without using the wire 50, but this configuration is not limiting. The edge portion of the light-emitting element 10 and the circuit pattern P1 located on the second surface S2 may be electrically connected by the wire 50 instead of the conductive material S. Alternatively, the light-emitting element 10 may be electrically connected directly to the circuit pattern P2 on the substrate 40 by the wire 50 without going through the circuit pattern P1.

In the above embodiment, the light-emitting element 10 has been described as being electrically connected to the circuit pattern P1 located on the second surface S2 by the transparent electrode 60 that covers the entire surface of the light-emitting element 10, but this configuration is not limiting. The light-emitting element 10 may be electrically connected to the circuit pattern P1 by a wire 50 instead of the transparent electrode 60. Alternatively, the light-emitting element 10 may be electrically connected directly to the circuit pattern P2 on the substrate 40 by the wire 50 without going through the circuit pattern P1.

In the above embodiment, the light-receiving element 30 has been described as having the recess 32 in the second surface S2 in which the light-emitting element 10 is disposed, but this configuration is not limiting. The light-receiving element 30 may be configured without the recess 32, so that the second surface S2 is flat.

In the above embodiment, the reflective optical unit 1 has been described as having a plurality of light-emitting elements 10 that are in close proximity to each other, but this configuration is not limiting. The plurality of light-emitting elements 10 do not need to be in close proximity to each other. Alternatively, the reflective optical unit 1 may have only a single light-emitting element 10, rather than a plurality of light-emitting elements 10.

In the above embodiment, the thickness of the light-emitting element 10 has been described as being in the range of 0.5 µm to 20 µm, but this configuration is not limiting. The thickness of the light-emitting element 10 may be in a range of more than 20 µm or a range of less than 0.5 µm, provided that the light-emitting element 10 has a thin-film shape.

In the above embodiment, the reflective optical unit 1 has been described as being used in an encoder, but this configuration is not limiting. The reflective optical unit 1 may be used in any other device other than an encoder.

In the above embodiment, the encoder has been described as including a rotary encoder, but this configuration is not limiting. The encoder may include other types of encoders different from rotary encoders. For example, the encoder may include a linear encoder. In this case, the reflector 20 may include a reflective linear scale.

## Claims

1. A reflective optical unit comprising:
a substrate; and
at least one light-emitting element and a light-receiving element located on the substrate, wherein
a difference between a first height of a first surface of the light-emitting element relative to the substrate, the first surface facing away from the substrate, and a second height of a second surface of the light-receiving element relative to the substrate, the second surface facing away from the substrate, is equal to or less than a thickness of the light-emitting element, and
the light-emitting element has a thin-film shape.

2. The reflective optical unit according to claim 1, wherein a tolerance of the difference is in a range of 0 µm to 5 µm.

3. The reflective optical unit according to claim 1 or 2, wherein
a reflector configured to reflect light, emitted from a light-emitting surface of the light-emitting element, toward a light-receiving surface of the light-receiving element, wherein
a first optical path length between the light-emitting surface included in the first surface and a reflecting surface of the reflector is defined as L1,
a second optical path length between the light-receiving surface included in the second surface and the reflecting surface is defined as L2, and
an error between L1 and L2 is in a range of 0 % to 5 %.

4. The reflective optical unit according to any one of claims 1 to 3, wherein
the light-receiving element is located directly above the substrate, and
the light-emitting element is located directly above the light-receiving element.

5. The reflective optical unit according to claim 4, wherein an edge portion of the light-emitting element and a circuit pattern located on the second surface are electrically connected directly via a conductive material without using a wire.

6. The reflective optical unit according to claim 4, wherein the light-emitting element is electrically connected to a circuit pattern located on the second surface by a transparent electrode that covers an entire surface of the light-emitting element.

7. The reflective optical unit according to any one of claims 4 to 6, wherein the light-receiving element comprises a recess in the second surface, and the light-emitting element is disposed in the recess.

8. The reflective optical unit according to any one of claims 1 to 7, wherein the at least one light-emitting element comprises a plurality of light-emitting elements in close proximity to each other.

9. The reflective optical unit according to any one of claims 1 to 8, wherein the thickness of the light-emitting element is in a range of 0.5 µm to 20 µm.

10. An encoder comprising the reflective optical unit according to claim 3.

11. The encoder according to claim 10, wherein
the encoder comprises a rotary encoder, and
the reflector comprises a code wheel.
